(19) Europäisches Patentamt
European Patent Office
Office européen des brevets

(11) **EP 3 814 789 B1**

(12) **FASCICULE DE BREVET EUROPEEN**

(45) Date de publication et mention
de la délivrance du brevet:
**03.08.2022   Bulletin 2022/31**

(21) Numéro de dépôt: **19729013.3**

(22) Date de dépôt: **11.06.2019**

(51) Classification Internationale des Brevets (IPC):
***G01R 31/11*** *(2006.01)*

(52) Classification Coopérative des Brevets (CPC):
**G01R 31/11**

(86) Numéro de dépôt international:
**PCT/EP2019/065108**

(87) Numéro de publication internationale:
**WO 2020/001966 (02.01.2020 Gazette 2020/01)**

(54) **PROCEDE DE CARACTERISATION D'UN DEFAUT DANS UN RESEAU DE LIGNES DE TRANSMISSION DE TOPOLOGIE INCONNUE**

VERFAHREN ZUR CHARAKTERISIERUNG EINES FEHLERS IN EINEM ÜBERTRAGUNGSLEITUNGSNETZ MIT UNBEKANNTER TOPOLOGIE

METHOD FOR CHARACTERISING A FAULT IN A TRANSMISSION LINE NETWORK WITH UNKNOWN TOPOLOGY

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **26.06.2018   FR 1855696**

(43) Date de publication de la demande:
**05.05.2021   Bulletin 2021/18**

(73) Titulaire: **Commissariat à l'Energie Atomique et aux Energies Alternatives**
**75015 Paris (FR)**

(72) Inventeurs:
• **KAFAL, Moussa**
**91940 LES ULIS (FR)**
• **BEN HASSEN, Wafa**
**75014 PARIS (FR)**

(74) Mandataire: **Marks & Clerk France**
**Immeuble "Visium"**
**22, avenue Aristide Briand**
**94117 Arcueil Cedex (FR)**

(56) Documents cités:
**WO-A1-2016/050547      WO-A1-2017/148753**
**WO-A1-2017/174400      WO-A1-2018/108526**
**FR-A1- 3 012 616         US-A1- 2013 173 187**
**US-B2- 7 282 922**

**Description**

L'invention concerne le domaine des systèmes de diagnostic filaires basés sur le principe de la réflectométrie. Elle a pour objet un procédé de caractérisation d'un défaut dans un réseau de lignes de transmission, par exemple un réseau de câbles, de topologie inconnue.

La caractérisation d'un défaut vise plus précisément la détection de l'existence d'un défaut à un endroit quelconque du réseau de lignes, la détermination de la position du défaut dans la topologie du réseau mais aussi la détermination de paramètres caractéristiques du défaut tels que la longueur du défaut et sa nature. La nature d'un défaut concerne l'information du paramètre linéique prépondérant du défaut. Si le paramètre linéique prépondérant est la résistance du défaut, on parle de défaut résistif. Si le paramètre linéique prépondérant est la conductance du défaut, on parle de défaut conductif. Si le paramètre linéique prépondérant est l'inductance du défaut, on parle de défaut inductif. Si le paramètre linéique prépondérant est la capacité du défaut, on parle de défaut capacitif. L'invention vise également à déterminer la valeur de chaque paramètre linéique du défaut qui peut être exprimée par rapport à la valeur de référence de ce même paramètre pour la ligne de transmission sur laquelle existe le défaut.

Les câbles sont omniprésents dans tous les systèmes électriques, pour l'alimentation ou la transmission d'information. Ces câbles sont soumis aux mêmes contraintes que les systèmes qu'ils relient et peuvent être sujets à des défaillances. Il est donc nécessaire de pouvoir analyser leur état et d'apporter des informations sur la détection de défauts, mais aussi leur localisation et leur type, afin d'aider à la maintenance. Les méthodes de réflectométrie usuelles permettent ce type de tests.

Les méthodes de réflectométrie utilisent un principe proche de celui du radar : un signal électrique, le signal de sonde ou signal de référence, qui est le plus souvent de haute fréquence ou large bande, est injecté en un ou plusieurs endroits du câble à tester. Le signal se propage dans le câble ou le réseau et renvoie une partie de son énergie lorsqu'il rencontre une discontinuité électrique. Une discontinuité électrique peut résulter, par exemple, d'un branchement, de la fin du câble ou d'un défaut ou plus généralement d'une rupture des conditions de propagation du signal dans le câble. Elle résulte le plus souvent d'un défaut qui modifie localement l'impédance caractéristique du câble en provoquant une discontinuité dans ses paramètres linéiques.

L'analyse des signaux renvoyés au point d'injection permet d'en déduire des informations sur la présence et la localisation de ces discontinuités, donc des défauts éventuels. Une analyse dans le domaine temporel ou fréquentiel est habituellement réalisée. Ces méthodes sont désignées par les acronymes TDR venant de l'expression anglo-saxonne « Time Domain Reflectometry » et FDR venant de l'expression anglo-saxonne « Frequency Domain Reflectometry ».

L'invention entre dans le champ d'application des méthodes de réflectométrie pour le diagnostic filaire et s'applique à tout type de câble électrique, en particulier des câbles de transmission d'énergie ou des câbles de communication, dans des installations fixes ou mobiles. Les câbles concernés peuvent être coaxiaux, bifilaires, en lignes parallèles, en paires torsadées ou autre pourvu qu'il soit possible d'y injecter un signal de réflectométrie en un point du câble et de mesurer sa réflexion au même point ou en un autre point.

Les méthodes de réflectométrie temporelle connues sont particulièrement adaptées à la détection de défauts francs dans un câble, tel un court circuit ou un circuit ouvert ou plus généralement une modification locale significative de l'impédance du câble. La détection du défaut se fait par la mesure de l'amplitude du signal réfléchi sur ce défaut qui est d'autant plus importante et donc détectable, que le défaut est important.

A l'inverse, un défaut non franc, par exemple résultant d'une dégradation superficielle de la gaine du câble de l'isolant ou du conducteur, engendre un pic d'amplitude faible sur le signal de réflectométrie réfléchi et est par conséquent plus difficilement détectable par des méthodes temporelles classiques. Plus généralement, un défaut non franc peut être provoqué par un frottement, un pincement ou encore un phénomène de corrosion qui vient affecter la gaine du câble, l'isolant ou le conducteur.

La détection et la localisation d'un défaut non franc sur un câble est un problème important pour le monde industriel car un défaut apparait en général d'abord comme un défaut superficiel mais peut, avec le temps, évoluer vers un défaut plus impactant. Pour cette raison notamment, il est utile de pouvoir détecter l'apparition d'un défaut dès son apparition et à un stade où son impact est superficiel afin d'anticiper son évolution en un défaut plus important. Par ailleurs, il est important également de connaitre la nature du défaut détecté et de le caractériser en déterminant son paramètre linéique prépondérant car cette information permet de caractériser le degré de dégradation engendré par le défaut et la vitesse probable de transformation du défaut non franc en défaut franc. En effet, un défaut de type résistif entraine une dégradation plus rapide qu'un défaut de type inductif ou capacitif. Cela est dû au fait que les défauts de type résistif résultent généralement d'une dégradation du conducteur du câble alors que les défauts de type inductif ou capacitif résultent plutôt d'une dégradation superficielle de l'isolant du câble.

Un autre problème que vise à résoudre l'invention concerne le diagnostic d'un réseau filaire de topologie inconnue dont les plans ne sont pas disponibles ou pour lesquels une intervention urgente nécessite la connaissance immédiate de la topologie du réseau. Ce type de problème existe notamment pour des réseaux de câbles électriques ou d'énergie à l'intérieur d'un bâtiment ou à l'intérieur d'un véhicule. Un technicien souhaitant effectuer un dépannage du réseau suite à la détection d'un problème électrique peut avoir besoin d'une connaissance précise de la topologie du réseau pour l'aider dans l'élaboration de son diagnostic. Par ailleurs, certains bâtiments présentent un niveau de confidentialité qui interdit, par nature, la diffusion des plans du réseau électrique.

Ainsi, un problème à résoudre concerne la détection et la caractérisation de défauts non francs dans un réseau de câbles dont la topologie n'est pas connue à priori.

Un autre problème est spécifique au domaine des méthodes de réflectométrie appliquées à la détection de défauts.

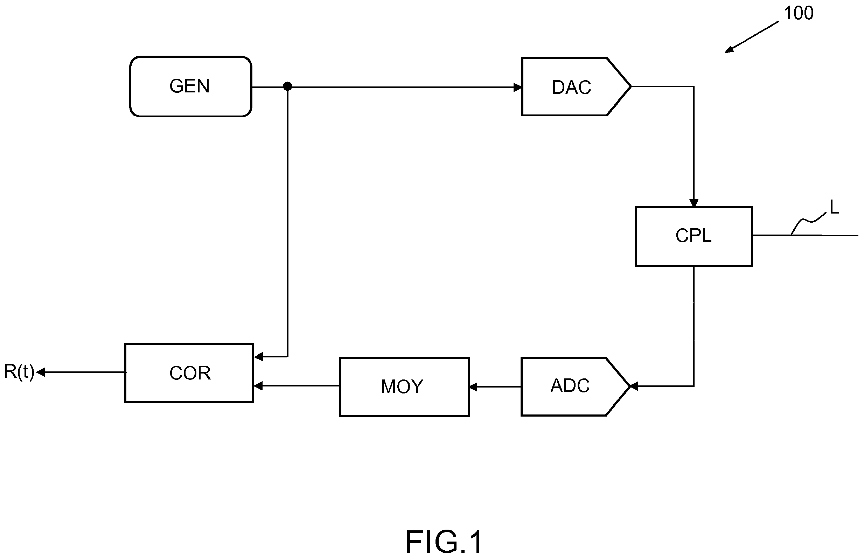

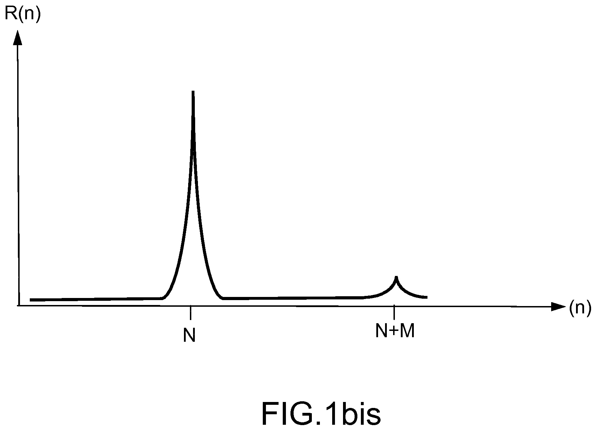

La figure 1 représente un schéma d'un système 100 d'analyse de défaut dans une ligne de transmission L, telle qu'un câble, selon une méthode usuelle de réflectométrie temporelle de l'état de l'art. Un tel système comprend principalement un générateur GEN d'un signal de référence. Le signal de référence numérique généré est converti analogiquement via un convertisseur numérique-analogique DAC puis est injecté en un point de la ligne de transmission L au moyen d'un coupleur directionnel CPL ou tout autre dispositif permettant d'injecter un signal dans une ligne. Le signal se propage le long de la ligne et se réfléchit sur les singularités qu'elle comporte. En l'absence de défaut sur la ligne, le signal se réfléchit sur l'extrémité de la ligne si la terminaison de la ligne est non adaptée. En présence de défaut sur la ligne, le signal se réfléchit partiellement sur la discontinuité d'impédance provoquée par le défaut. Le signal réfléchi est rétro-propagé jusqu'à un point de mesure, qui peut être commun au point d'injection ou différent. Le signal rétro-propagé est mesuré via le coupleur directionnel CPL puis converti numériquement par un convertisseur analogique numérique ADC. Une corrélation COR est ensuite effectuée entre le signal numérique mesuré et une copie du signal numérique généré avant injection afin de produire un réflectogramme temporel R(t) correspondant à l'inter-corrélation entre les deux signaux.

Comme cela est connu dans le domaine des méthodes de diagnostic par réflectométrie temporelle, la position $d_{DF}$ d'un défaut sur le câble L, autrement dit sa distance au point d'injection du signal, peut être directement obtenue à partir de la mesure, sur le réflectogramme temporel calculé R(t), de la durée $t_{DF}$ entre le premier pic d'amplitude relevé sur le réflectogramme et le pic d'amplitude correspondant à la signature du défaut.

La figure 1bis représente un exemple de réflectogramme R(n) obtenu à l'aide du système de la figure 1, sur lequel on observe un premier pic d'amplitude à une abscisse N et un second pic d'amplitude à une abscisse N+M. Le premier pic d'amplitude correspond à la réflexion du signal au point d'injection dans le câble, tandis que le second pic correspond à la réflexion du signal sur une discontinuité d'impédance provoquée par un défaut

Différentes méthodes connues sont envisageables pour déterminer la position $d_{DF}$. Une première méthode consiste à appliquer la relation liant distance et temps : $d_{DF} = V_g \cdot t_{DF}/2$ où $V_g$ est la vitesse de propagation du signal dans le câble. Une autre méthode possible consiste à appliquer une relation de proportionnalité du type $d_{DF}/ t_{DF} = L_c/t_0$ où $L_c$ est la longueur du câble et $t_0$ est la durée, mesurée sur le réflectogramme, entre le pic d'amplitude correspondant à la discontinuité d'impédance au point d'injection et le pic d'amplitude correspondant à la réflexion du signal sur l'extrémité du câble.

Un dispositif d'analyse (non représenté à la figure 1) est chargé d'analyser le réflectogramme R(t) pour en déduire des informations de présence et/ou localisation de défauts ainsi que les caractéristiques électriques éventuelles des défauts. En particulier, l'amplitude d'un pic dans le réflectogramme est directement liée au coefficient de réflexion du signal sur la discontinuité d'impédance provoquée par le défaut.

La détection et la localisation de défauts au moyen d'un système de réflectométrie présente un intérêt important car plus tôt un défaut est détecté, plus il est possible d'intervenir pour corriger/réparer le défaut avant que la dégradation ne soit trop importante. Ainsi, la surveillance de l'état de santé d'un câble permet de maintenir un usage fiable du câble pendant toute sa durée de vie.

Dans le cas d'un réseau de câbles complexe comprenant de nombreuses interconnexions, l'analyse d'un réflectogramme en vue de caractériser la présence de défauts est plus difficile à mettre en oeuvre car les jonctions entre les différents câbles du réseau ainsi que les charges en fin de câbles entrainent également des réflexions du signal qui peuvent se superposer à celles résultant d'un défaut. En particulier, des réflexions multiples peuvent exister entre plusieurs jonctions ou plus généralement plusieurs points singuliers du réseau. Les superpositions de réflexions multiples du signal sur différents points singuliers du réseau peuvent s'annuler mutuellement, se renforcer ou se combiner de sorte à créer de nombreux pics parasites dans le réflectogramme. Par ailleurs, le nombre de réflexions du signal tend à augmenter exponentiellement avec le nombre de câbles interconnectés dans le réseau. Ainsi, les réseaux de câbles complexes produisent des réflectogrammes très complexes à analyser.

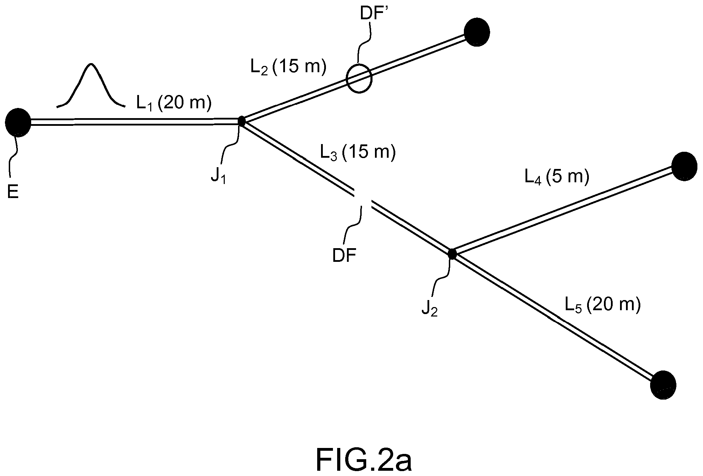

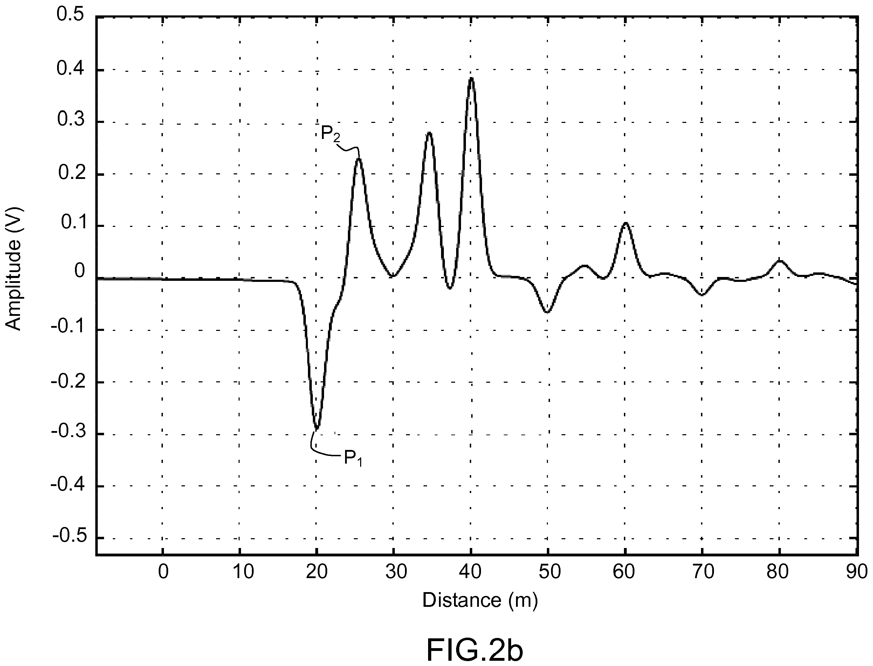

En particulier, même si un pic caractéristique d'un défaut peut être identifié dans un réflectogramme, la localisation du défaut peut être ambigüe car le réflectogramme permet uniquement de connaitre la distance entre le défaut et le point d'injection du signal, mais pas sur quelle branche du réseau est situé le défaut. Pour illustrer ce phénomène, un exemple de réseau de câbles comprenant cinq branches et deux jonctions est représenté sur la figure 2a. Le réflectogramme associé à ce réseau est illustré sur la figure 2b, en considérant l'injection et la mesure du signal au point E du réseau. Sur le réflectogramme, on identifie un premier pic P1 d'amplitude négative qui correspond à la première jonction J1, puis un deuxième pic P2 qui correspond à un défaut DF. La localisation précise de ce défaut DF n'est pas possible car il peut être situé soit sur la branche L2 au point DF', soit sur la branche L3 au point DF. Les autres pics du réflectogramme correspondent à des réflexions directes ou multiples sur les extrémités des différents câbles ainsi que sur la seconde jonction J2.

On voit donc que les méthodes de surveillance de l'état de santé d'un réseau de câbles, par réflectométrie, ne sont pas suffisantes lorsque le réseau de câbles est complexe, c'est-à-dire qu'il présente de nombreuses branches et interconnexions.

Il existe donc un besoin pour une méthode permettant de caractériser un défaut dans un réseau de câbles de topologie inconnue.

L'état de l'art comporte les documents suivants : WO 2017/174400 et US 7282922.

L'invention vise à proposer une méthode et un dispositif permettant de caractériser la présence, la position, la sévérité et la nature d'un défaut dans un réseau de lignes de transmission de topologie inconnue. L'invention permet de fournir des informations utiles à la maintenance d'un réseau de câbles.

L'invention permet d'obtenir un tel résultat par le biais d'une méthode d'optimisation utilisant des réflectogrammes simulés de différentes hypothèses de topologie du réseau et de nature du défaut et en comparant les réflectogrammes simulés à un réflectogramme mesuré sur le réseau de câbles sous test.

L'invention présente notamment l'avantage de permettre une caractérisation plus précise de la nature d'un défaut non franc détecté, par rapport aux méthodes de l'art antérieur.

L'invention a pour objet un procédé de caractérisation d'un défaut dans un réseau de lignes de transmission, le procédé comprenant les étapes de :

- Obtenir un premier réflectogramme temporel mesuré $R_m$ à partir d'un signal préalablement injecté dans le réseau de câbles,
- Obtenir un second réflectogramme temporel $R_s$ correspondant au réseau de lignes de transmission en l'absence de défauts,
- Déterminer la différence temporelle $R_{ref}$ entre le premier réflectogramme temporel mesuré $R_m$ et le second réflectogramme temporel $R_s$,
- Identifier, dans ladite différence temporelle $R_{ref}$, un pic d'amplitude caractérisant la présence d'un défaut et son abscisse temporelle indiquant la position du défaut,
- Simuler une pluralité d'hypothèses de réflectogrammes temporels correspondant chacun audit réseau de câbles comprenant un défaut à ladite position identifiée, chaque hypothèse étant associée à une valeur différente d'au moins un paramètre caractéristique du défaut,
- Sélectionner l'hypothèse de réflectogramme temporel la plus proche de ladite différence temporelle $R_{ref}$,
- Caractériser le défaut à partir de l'au moins un paramètre caractéristique associé à l'hypothèse sélectionnée.

Selon un aspect particulier de l'invention, le paramètre caractéristique du défaut est pris parmi la longueur du défaut, la valeur d'au moins un paramètre linéique du défaut parmi la résistance, l'inductance, la capacité ou la conductance, la nature du défaut définie par au moins un paramètre linéique prépondérant du défaut.

Selon un aspect particulier de l'invention, la valeur d'au moins un paramètre linéique est déterminée par rapport à la valeur du même paramètre linéique de la ligne de transmission.

Selon un aspect particulier de l'invention, l'étape de déterminer l'hypothèse de réflectogramme temporel la plus proche de ladite différence temporelle comprend au moins la comparaison de chaque hypothèse de réflectogramme temporel avec ladite différence temporelle sur une fenêtre temporelle autour du pic d'amplitude caractérisant la présence d'un défaut.

Selon un aspect particulier de l'invention, la comparaison est réalisée au moyen d'un calcul d'erreur entre l'hypothèse de réflectogramme temporel et la différence temporelle.

Selon un aspect particulier de l'invention, l'étape de déterminer l'hypothèse de réflectogramme temporel la plus proche de ladite différence temporelle est réalisée au moyen d'un algorithme d'optimisation du type basé sur la méthode de Newton ou du type algorithme génétique.

Selon un aspect particulier de l'invention, le second réflectogramme temporel $R_s$ correspondant au réseau de lignes de transmission en l'absence de défauts est déterminé par simulation.

Selon un aspect particulier de l'invention, le second réflectogramme temporel $R_s$ correspondant au réseau de lignes de transmission en l'absence de défauts est déterminé par simulation à partir du premier réflectogramme temporel mesuré $R_m$ sans connaissance a priori de la topologie du réseau de lignes.

Selon un aspect particulier de l'invention, l'étape de déterminer un second réflectogramme temporel $R_s$ correspondant au réseau de lignes de transmission en l'absence de défauts comprend les sous-étapes de :

- Simuler initialement une pluralité d'hypothèses de réseaux de câbles $H_{i,j}$, puis exécuter itérativement les étapes suivantes :

- Obtenir, pour chaque hypothèse de réseau de câbles simulé $H_{i,j}$, un réflectogramme temporel simulé associé $R_{i,j}$,
- Evaluer, pour chaque hypothèse de réseau de câbles simulé $H_{i,j}$, un critère d'erreur $E(R_{i,j}-R_m)$ entre le réflectogramme temporel mesuré $R_m$ et le réflectogramme temporel simulé $R_{i,j}$,
- Appliquer auxdits réseaux de câbles simulés un algorithme d'optimisation ayant pour fonction de produire une pluralité de réseaux de câbles modifiés présentant globalement un critère d'erreur $E(R_{i,j}-R_m)$ diminué,
- Remplacer lesdits réseaux de câbles simulés de l'itération précédente par lesdits réseaux de câbles modifiés pour l'itération suivante.

Selon une variante de réalisation, le procédé selon l'invention comprend une étape d'affichage de la localisation du défaut dans le réseau de lignes de transmission et de l'au moins un paramètre caractéristique du défaut, sur un dispositif d'affichage.

Selon une variante de réalisation, le procédé selon l'invention comprend une étape préalable d'injection du signal dans le réseau de lignes de transmission.

L'invention a aussi pour objet un programme d'ordinateur téléchargeable depuis un réseau de communication et/ou enregistré sur un support lisible par ordinateur et/ou exécutable par un processeur, caractérisé en ce qu'il comprend des instructions de code pour l'exécution des étapes d'un procédé selon l'invention, lorsque ledit programme est exécuté sur un ordinateur.

L'invention a encore pour objet un dispositif de caractérisation d'un défaut dans un réseau de lignes de transmission comprenant des moyens configurés pour mettre en œuvre le procédé selon l'invention.

D'autres caractéristiques et avantages de la présente invention apparaîtront mieux à la lecture de la description qui suit en relation aux dessins annexés qui représentent :

- La figure 1, un schéma d'un système de réflectométrie selon l'art antérieur,
- La figure 1bis, un exemple de réflectogramme obtenu avec le système de réflectométrie de la figure 1 pour un câble simple,
- La figure 2a, un exemple de réseau de câbles comprenant plusieurs branches et jonctions,
- La figure 2b, un exemple de réflectogramme temporel obtenu pour le réseau de câbles de la figure 2a,
- La figure 3, un organigramme décrivant les étapes du procédé selon un mode de réalisation de l'invention,
- La figure 4a, un exemple de réseau de câbles comportant un défaut non franc,
- Les figures 4b,4c,4d, trois réflectogrammes temporels illustrant certaines étapes du procédé selon l'invention appliqué au réseau de la figure 4a,
- La figure 5, un organigramme détaillant les étapes de mise en oeuvre d'un exemple de réalisation d'une étape du procédé selon l'invention.

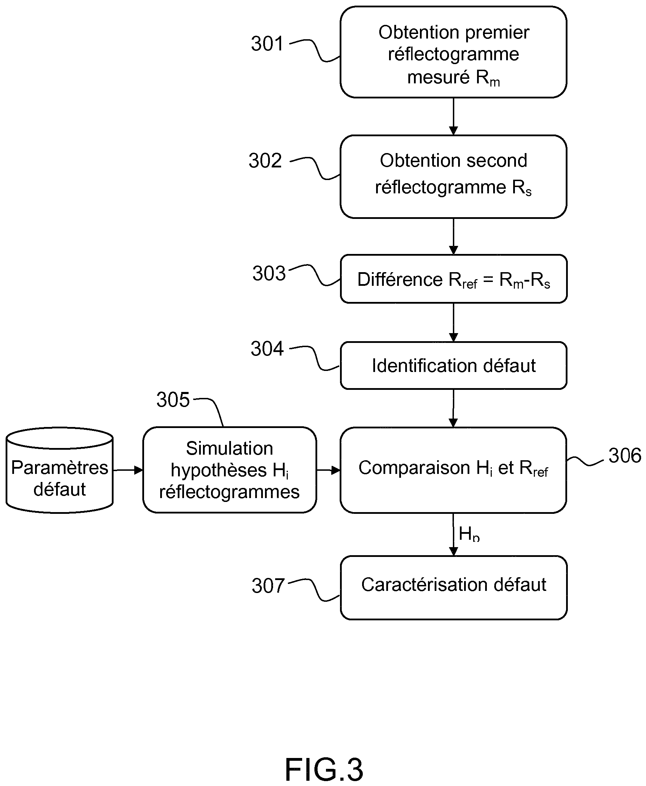

La figure 3 schématise, sur un organigramme, les étapes de mise en œuvre du procédé selon un mode de réalisation de l'invention.

Dans une première étape 301 du procédé, un réflectogramme temporel $R_m$ est obtenu à partir d'une mesure de réflectométrie. Comme indiqué en préambule, une mesure de réflectométrie est obtenue en injectant un signal maitrisé en un point du réseau de câbles puis en mesurant, au même point ou en un point différent du réseau, le signal qui est rétro-propagé après avoir subi de multiples réflexions sur les discontinuités d'impédance apparaissant dans les câbles du réseau. La mesure de réflectométrie peut être obtenue au moyen du dispositif décrit à la figure 1 ou tout autre équipement équivalent permettant de réaliser la même fonction. Le signal utilisé peut être de nature diverse, il peut s'agir d'un simple signal Gaussien, d'un créneau temporel ou d'une impulsion ou bien d'un signal plus complexe. En fonction de la nature exacte du signal, le réflectogramme temporel $R_m$ est obtenu directement par la mesure du signal rétro-propagé ou bien par un calcul d'inter-corrélation entre cette mesure et une copie du signal injecté dans le réseau. De façon générale, toute mesure de signal comprenant l'information relative aux réflexions du signal sur les points singuliers du réseau, c'est-à-dire les jonctions et les charges en fin de câbles, est compatible de l'invention. Il convient de noter que la mesure du réflectogramme temporel $R_m$ ne nécessite l'accès qu'à un seul port de test du réseau.

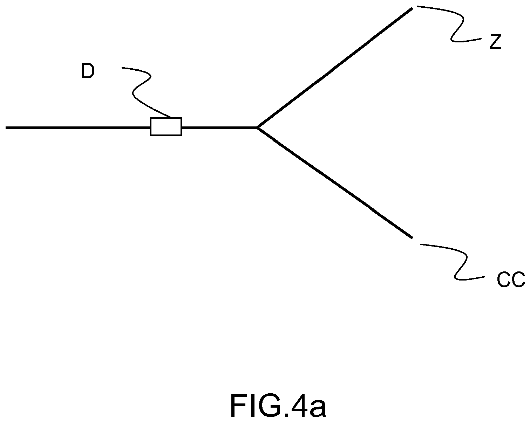

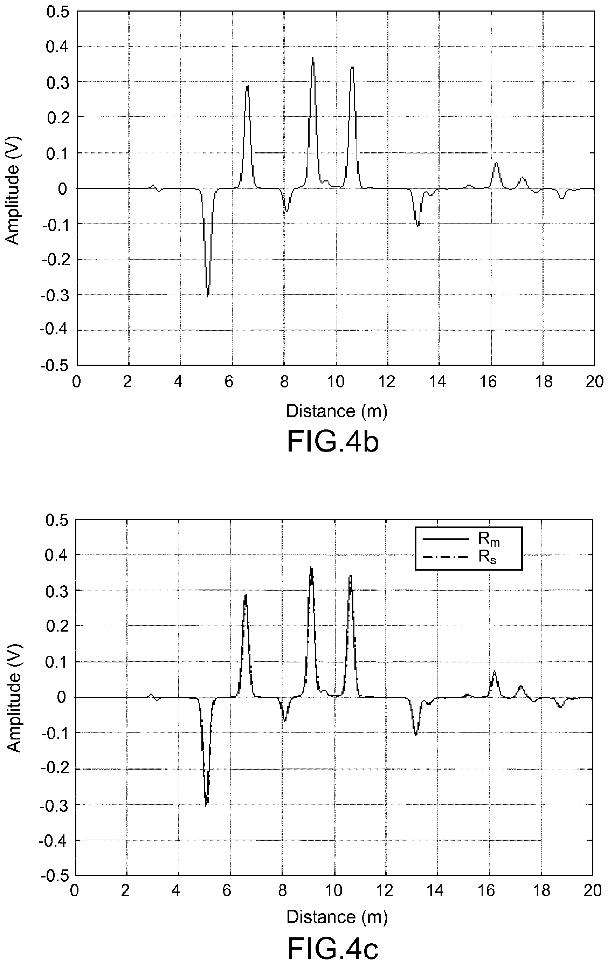

La figure 4b illustre un exemple de réflectogramme temporel $R_m$ mesuré pour un exemple de réseau décrit à la figure 4a. Le réseau est composé de 3 branches reliées à une jonction. Le signal est injecté et mesuré à l'extrémité de la première branche. La deuxième branche est terminée par une charge Z et la troisième branche est terminée par un court circuit CC. Un défaut non franc D est situé sur la première branche.

Dans une deuxième étape 302 du procédé, un second réflectogramme temporel $R_s$ est déterminé, ce réflectogramme correspondant au réseau de câbles sain, c'est-à-dire sans défaut franc.

Selon une première variante de l'étape 302, le second réflectogramme temporel $R_s$ est déterminé au préalable, lors de l'installation du réseau de câbles, lorsque celui-ci est sain, c'est-à-dire sans défaut, afin d'avoir une référence. Dans ce cas, le second réflectogramme temporel $R_s$ est déterminé par une mesure de réflectométrie identique à celle décrite à la première étape 301.

Cependant, il n'est pas toujours possible de réaliser une mesure par réflectométrie initiale lors de l'installation du réseau de câbles ou cette mesure n'est pas toujours disponible au moment où l'on souhaite réaliser le diagnostic de maintenance du réseau.

C'est pourquoi, selon une deuxième variante de l'étape 302, le second réflectogramme temporel $R_s$ est déterminé par simulation à partir de la connaissance a priori de la topologie du réseau de câbles. La simulation est réalisée, par exemple, en appliquant un modèle numérique de la propagation du signal à travers les câbles du réseau simulé. En particulier, ce modèle prend en compte les coefficients de réflexion et les coefficients de transmission sur chaque jonction ou chaque charge que comprend le réseau simulé. L'Homme du métier peut utiliser ses connaissances générales sur la propagation des ondes pour déterminer un réflectogramme simulé, notamment en se basant sur les équations du télégraphiste qui permettent de décrire l'évolution de la tension et du courant sur une ligne électrique en fonction de la distance et du temps.

$$\frac{\partial v(x,t)}{\partial x} = -Ri(x,t) - L\frac{\partial i(x,t)}{\partial t} \qquad (1)$$

$$\frac{\partial i(x,t)}{\partial x} = -Gv(x,t) - C\frac{\partial v(x,t)}{\partial t} \qquad (2)$$

Les paramètres R,L,C,G correspondent respectivement à la résistance, à l'inductance, à la capacitance et à la conductance de la ligne.

Dans une troisième variante de l'étape 302, lorsque la topologie du réseau n'est pas connue a priori, le second réflectogramme temporel $R_s$ est simulé, à partir du premier réflectogramme temporel mesuré $R_m$ en appliquant un algorithme d'optimisation du type décrit dans la demande de brevet français du Demandeur déposée sous le numéro FR 1757650.

Cette troisième variante est décrite plus en détail en annexe de la description.

La figure 4c représente, sur un même diagramme temporel, le premier réflectogramme temporel mesuré $R_m$ et le second réflectogramme temporel $R_s$ obtenu par simulation.

Dans une étape suivante 303, on détermine la différence temporelle, point à point, entre le premier réflectogramme temporel mesuré $R_m$ et le second réflectogramme temporel $R_s$ afin de produire un réflectogramme dans lequel seuls les pics d'amplitude correspondant à des défauts non francs apparaissent. En effet, l'étape 303 a pour but de supprimer du réflectogramme obtenu tous les pics d'amplitude correspondants aux réflexions du signal sur des jonctions ou des extrémités des câbles du réseau qui sont contenus dans le second réflectogramme temporel $R_s$ caractérisant le réseau seul, sans défauts.

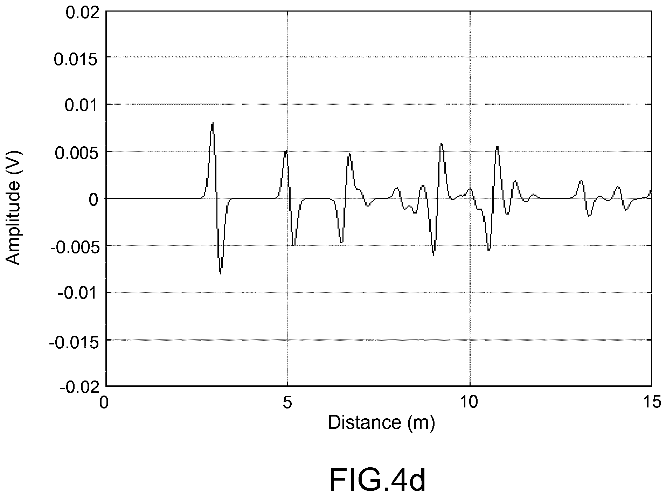

La figure 4d représente le réflectogramme obtenu à l'étape 303. Le premier pic d'amplitude A correspond à la première réflexion du signal sur le défaut D.

Dans une étape suivante 304, on identifie la présence d'un défaut sur le réflectogramme obtenu à l'étape 303, et on détermine sa position à partir de la mesure de l'abscisse temporelle du défaut.

A l'issue de cette étape 304, on a identifié la présence d'un défaut et on sait estimer sa position dans le réseau à partir de la différence calculée à l'étape 303 ou plus généralement de la comparaison entre d'une part le premier réflectogramme mesuré $R_m$ qui comprend des réflexions du signal sur toutes les discontinuités d'impédance du réseau, défauts compris, et d'autre part le second réflectogramme $R_s$ qui ne comprend que des réflexions du signal sur les jonctions et terminaisons structurelles du réseau.

La suite du procédé vise à caractériser plus précisément le défaut détecté pour déterminer son degré de sévérité et/ou sa propension à se dégrader vers un défaut majeur et à quelle vitesse.

Dans l'étape 305 suivante, on détermine plusieurs hypothèses de défaut, chaque hypothèse étant définie par au moins un paramètre parmi la longueur du défaut, la valeur de chaque paramètre linéique du défaut et la nature du défaut, c'est-à-dire son paramètre linéique prépondérant,

La valeur de chaque paramètre linéique peut être exprimée comme une valeur relative par rapport à la valeur du même paramètre linéique de la ligne de transmission sur laquelle se situe le défaut. L'ensemble des valeurs des paramètres linéiques caractérisant un défaut permet de définir la sévérité du défaut.

La longueur du défaut peut être approximée en première approche à partir de la largeur temporelle de l'impulsion caractéristique du défaut sur le réflectogramme. Puis, plusieurs hypothèses de largeurs sont prises pour affiner cette valeur.

Il existe quatre paramètres linéiques R,L,C,G permettant de caractériser un défaut. La valeur de chacun de ces paramètres ou sa valeur relative par rapport à la valeur du même paramètre linéique pour la ligne de transmission correspond à la sévérité du défaut.

Ensuite, la nature d'un défaut est caractérisée par son paramètre linéique prépondérant.

Un paramètre linéique est prépondérant si sa valeur est significativement supérieure à celle des autres paramètres. Par exemple, si le paramètre linéique prépondérant est la résistance R, le défaut est de nature résistive. Si le paramètre linéique prépondérant est l'inductance L, le défaut est de nature inductive. Si le paramètre linéique prépondérant est la capacité C, le défaut est de nature capacitive. Si le paramètre linéique prépondérant est la conductance G, le défaut est de nature conductive.

Un défaut peut également présenter plusieurs paramètres linéiques prépondérants. De façon générale, un défaut est caractérisé par les valeurs respectives des quatre paramètres linéiques R,L,C,G.

La connaissance de la nature d'un défaut permet de caractériser la vitesse de dégradation du défaut non franc en un défaut franc. Par exemple, un défaut de nature résistive présente une vitesse de dégradation plus importante qu'un défaut de nature capacitive ou inductive. La vitesse de dégradation dépend néanmoins également de l'environnement du câble. En particulier les conditions d'humidité, de pression ou de vibrations influent également sur la vitesse de dégradation. Cette information présente donc un intérêt important pour diagnostiquer l'influence d'un défaut non franc détecté sur la maintenance future d'un réseau de câbles.

L'étape 305 consiste, pour chaque hypothèse de défaut, à simuler un réflectogramme du réseau de câbles comprenant l'hypothèse de défaut à la position identifiée à l'étape 304.

La simulation est basée, notamment sur des modèles de propagation qui donnent la forme d'une impulsion de signal réfléchie sur un défaut selon sa nature. Par exemple, on sait qu'une impulsion de signal réfléchie sur un défaut résistif prend la forme d'une impulsion positive. A l'inverse, une impulsion de signal réfléchie sur un défaut conductif prend la forme d'une impulsion négative. Une impulsion de signal réfléchie sur un défaut inductif prend la forme d'une impulsion positive suivie d'une impulsion négative. Une impulsion de signal réfléchie sur un défaut capacitif prend la forme d'une impulsion négative suivie d'une impulsion positive.

La valeur du paramètre linéique défini l'amplitude de l'impulsion.

La simulation d'un réflectogramme pour chaque hypothèse de défaut prend en compte les caractéristiques du défaut et les caractéristiques complètes du réseau dont la topologie a été déterminée à l'étape 302.

La modélisation de l'effet d'un défaut non franc sur un réflectogramme est réalisée en considérant le défaut non franc comme une discontinuité d'impédance qui est modélisée par une section de ligne de transmission de petite dimension ayant des paramètres R,L,C,G modifiés par rapport à ceux de la ligne sans défaut. Des hypothèses sont prises pour les valeurs respectives de chacun des paramètres R,L,C,G ou pour les valeurs relatives de ces paramètres par rapport aux paramètres correspondants de la ligne de transmission sur laquelle est située le défaut.

Le réflectogramme associé à la réflexion du signal sur un défaut non franc est simulé par un modèle numérique qui quantifie la propagation du signal le long des lignes de transmission qui composent le réseau à analyser. Un tel modèle numérique est obtenu, par exemple, à partir des équations du télégraphiste (1) et (2) introduites précédemment qui permettent de modéliser l'évolution de la tension et du courant le long d'une ligne de transmission.

Une méthode de modélisation possible est la méthode de calcul de différences finies dans le domaine temporel, ou « finite difference time demain » en anglais appliquée aux équations du télégraphiste. Cette méthode permet de modéliser la réponse impulsionnelle d'un réseau de lignes et donc la propagation d'un signal dans un tel réseau.

Cette méthode de modélisation est appliquée de façon similaire pour modéliser la réflexion du signal sur une section de ligne ayant des paramètres R,L,C,G correspondant à la discontinuité d'impédance générée par le défaut.

Ensuite, dans une étape 306, on effectue une comparaison de chaque hypothèse de réflectogramme simulé $H_i$ avec la différence temporelle $R_{ref}$ déterminée à l'étape 303.

La comparaison, est par exemple, effectuée sur une fenêtre temporelle encadrant l'impulsion correspondant au défaut.

La comparaison est réalisée, par exemple, au moyen d'un algorithme d'optimisation du type algorithme génétique ou algorithme de Newton ou toute autre méthode numérique d'optimisation permettant de déterminer l'hypothèse $H_i$ la plus proche de la différence temporelle $R_{ref}$.

Le critère de comparaison utilisé est, par exemple, un critère de distance entre les deux réflectogrammes $H_i$ et $R_{ref}$, par exemple une erreur quadratique moyenne. Le critère de distance ou d'erreur traduit la proximité ou la ressemblance entre les deux réflectogrammes. Il peut consister en une simple différence point à point entre les deux réflectogrammes ou en un calcul de distance plus élaboré. Par exemple, le critère d'erreur peut être égal à la norme euclidienne ou norme 2 de la différence entre les deux réflectogrammes. La norme euclidienne est égale à la racine carrée de la somme des carrés des valeurs de différence point à point entre les deux réflectogrammes. Toute autre distance ou norme peut être envisagée.

A l'issue de l'étape 306, une seule hypothèse $H_p$ est retenue et le défaut est ensuite caractérisé 307 à partir des paramètres de l'hypothèse retenue qui comprennent au moins un paramètre parmi la longueur du défaut, la sévérité du défaut exprimée par la valeur de chaque paramètre linéique du défaut qui peut être exprimée par rapport à la valeur du même paramètre linéique de la ligne de transmission et la nature du défaut caractérisée par le ou les paramètre(s) linéique(s) prépondérant(s).

Le procédé selon l'invention peut être mis en oeuvre en tant que programme d'ordinateur, le procédé étant appliqué à une mesure de réflectométrie $R_m$ préalablement acquise à l'aide d'un dispositif de réflectométrie usuel. L'invention peut être mise en œuvre en tant que programme d'ordinateur comportant des instructions pour son exécution. Le programme d'ordinateur peut être enregistré sur un support d'enregistrement lisible par un processeur. La référence à un programme d'ordinateur qui, lorsqu'il est exécuté, effectue l'une quelconque des fonctions décrites précédemment, ne se limite pas à un programme d'application s'exécutant sur un ordinateur hôte unique. Au contraire, les termes programme d'ordinateur et logiciel sont utilisés ici dans un sens général pour faire référence à tout type de code informatique (par exemple, un logiciel d'application, un micro logiciel, un microcode, ou toute autre forme d'instruction d'ordinateur) qui peut être utilisé pour programmer un ou plusieurs processeurs pour mettre en œuvre des aspects des techniques décrites ici. Les moyens ou ressources informatiques peuvent notamment être distribués *("Cloud computing"),* éventuellement selon des technologies de pair-à-pair. Le code logiciel peut être exécuté sur n'importe quel processeur approprié (par exemple, un microprocesseur) ou cœur de processeur ou un ensemble de processeurs, qu'ils soient prévus dans un dispositif de calcul unique ou répartis entre plusieurs dispositifs de calcul (par exemple tels qu'éventuellement accessibles dans l'environnement du dispositif). Le code exécutable de chaque programme permettant au dispositif programmable de mettre en œuvre les processus selon l'invention, peut être stocké, par exemple, dans le disque dur ou en mémoire morte. De manière générale, le ou les programmes pourront être chargés dans un des moyens de stockage du dispositif avant d'être exécutés. L'unité centrale peut commander et diriger l'exécution des instructions ou portions de code logiciel du ou des programmes selon l'invention, instructions qui sont stockées dans le disque dur ou dans la mémoire morte ou bien dans les autres éléments de stockage précités.

L'invention peut aussi être mise en oeuvre dans un dispositif embarqué du type de celui de la figure 1 comprenant en outre au moins un calculateur et une mémoire configurés pour exécuter le procédé selon l'invention afin de fournir, à partir d'un réflectogramme mesuré $R_m$, une caractérisation de la présence d'un défaut dans le réseau de câbles auquel est connecté le dispositif. Cette caractérisation comprenant au moins la position du défaut dans le réseau et une information parmi la longueur, la nature et la variation de la valeur du paramètre linéique prépondérant.

Le dispositif peut comporter également un moyen d'affichage des résultats du procédé sous forme de graphe ou sous forme numérique. Par exemple, la topologie complète du réseau est affichée avec la position du défaut et ses paramètres détectés.

## ANNEXE

On reprend ici une partie de la description de la demande de brevet française du Demandeur déposée sous le numéro FR 1757650 qui décrit en détail plusieurs modes de réalisation de l'étape 302 du procédé objet de la présente invention. L'Homme du métier peut se référer à cette demande pour mettre en œuvre d'autres variantes de réalisation de l'étape 302.

Un objectif de l'étape 302 est de fournir une reconstruction de la topologie d'un réseau totalement ou partiellement inconnu ainsi que du réflectogramme temporel associé à ce réseau. Les informations fournies par cette étape comprennent, par exemple le nombre de jonctions ou points de connexions du réseau, le nombre de branches ou sections de câbles connectées en chaque jonction, la longueur de chaque branche ainsi que l'impédance caractéristique de chaque branche et la valeur de l'impédance de la charge en fin de branche, c'est-à-dire à l'extrémité d'un câble qui n'est pas relié à un autre câble. L'étape 302 peut fournir toutes ces informations afin de produire une reconstruction complète de la topologie d'un réseau ou fournir une partie seulement de ces informations. Le nombre et le type d'informations caractérisant la topologie d'un réseau est un paramètre de l'invention qui est spécifié par un utilisateur.

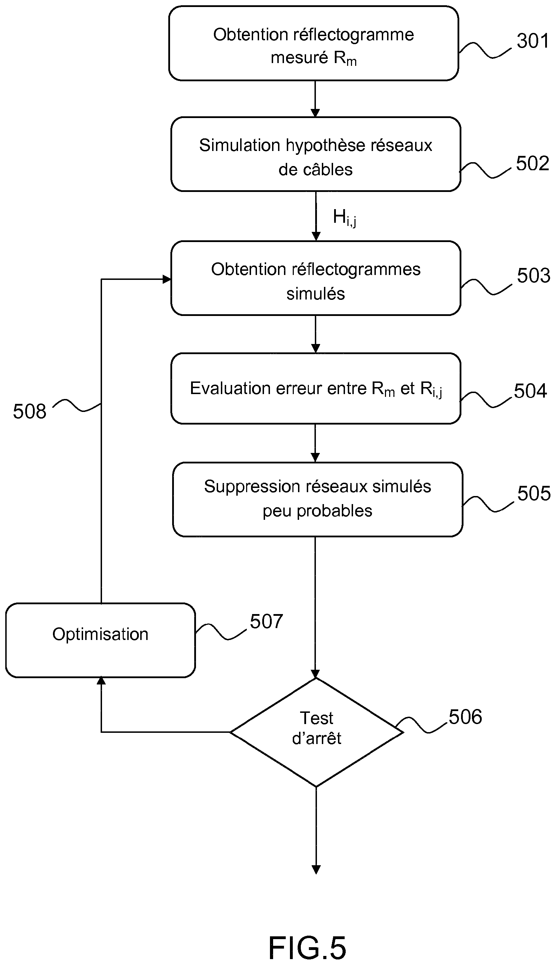

La figure 5 schématise, sur un organigramme, les étapes de mise en œuvre d'un exemple de réalisation de l'étape 302.

La première étape 301 du procédé décrit à la figure 5 est identique à la première étape du procédé de la figure 3 et consiste à déterminer un réflectogramme temporel $R_m$ est obtenu à partir d'une mesure de réflectométrie.

Dans une deuxième étape 502, on simule plusieurs hypothèses de topologie de réseaux de câbles possibles en tenant compte de contraintes globales sur le réseau à reconstruire, par exemple les nombres maximum et minimum de branches et de jonctions que peut comporter le réseau mais aussi des bornes sur les valeurs numériques des impédances et des longueurs des branches.

Les paramètres de reconstruction d'un réseau sont de deux natures. D'une part on retrouve les paramètres structurels de la topologie d'un réseau que sont le nombre de jonctions et le nombre de branches connectées à chaque jonction. D'autre part, on a également les paramètres numériques de la topologie que sont les longueurs des branches, les valeurs des impédances caractéristiques des branches et les valeurs des impédances des charges en fin de chaque extrémité du réseau.

L'ensemble des hypothèses de réseaux simulés doit parcourir tous les paramètres structurels de topologie possibles et doit comprendre plusieurs hypothèses de paramètres numériques pour chaque hypothèse structurelle.

Une possibilité exhaustive consiste à simuler toutes les valeurs de paramètres numériques et tous les paramètres structurels afin de simuler toutes les hypothèses possibles.

Par la suite, on note $H_{i,j}$ une hypothèse de réseau simulé, avec i un indice indexant une hypothèse de paramètres structurels et j un indice indexant une hypothèse de paramètres numériques. L'indice i varie de 1 à $N_{st}$ où $N_{st}$ est le nombre d'hypothèses possibles de paramètres structurels. L'indice j varie dans un sous-ensemble de l'ensemble des hypothèses possibles de paramètres numériques, ce sous-ensemble étant au plus égal à l'ensemble total des hypothèses de paramètres numériques.

Ensuite, pour chaque hypothèse de topologie simulée, on détermine 503 un réflectogramme temporel simulé associé à cette topologie. Pour cela, on considère le même signal que celui utilisé pour obtenir le réflectogramme mesuré $R_m$ et les mêmes conditions d'injection du signal et de mesure du signal rétro-propagé. Le signal rétro-propagé est simulé, par exemple, en appliquant un modèle numérique de la propagation du signal à travers les câbles du réseau simulé. En particulier, ce modèle prend en compte les coefficients de réflexion et les coefficients de transmission sur chaque jonction ou chaque charge que comprend le réseau simulé. L'Homme du métier peut utiliser ses connaissances générales sur la propagation des ondes pour déterminer un réflectogramme simulé, notamment en se basant sur les équations du télégraphiste qui permettent de décrire l'évolution de la tension et du courant sur une ligne électrique en fonction de la distance et du temps.

$$\frac{\partial v(x,t)}{\partial x} = -Ri(x,t) - L\frac{\partial i(x,t)}{\partial t} \qquad (1)$$

$$\frac{\partial i(x,t)}{\partial x} = -Gv(x,t) - C\frac{\partial v(x,t)}{\partial t} \qquad (2)$$

Les paramètres R,L,C,G correspondent respectivement à la résistance, à l'inductance, à la capacitance et à la conductance de la ligne.

A l'issue de l'étape 503, on obtient plusieurs réflectogrammes simulés $R_{i,j}$ correspondant aux hypothèses $H_{i,j}$

A l'étape suivante 504, on calcule, pour chaque hypothèse de topologie simulée, un critère d'erreur entre le réflectogramme mesuré $R_m$ obtenu à l'étape 301 et le réflectogramme $R_{i,j}$ du réseau simulé. Le critère d'erreur traduit la proximité ou la ressemblance entre les deux réflectogrammes. Il peut consister en une simple différence point à point entre les deux réflectogrammes ou en un calcul de distance plus élaboré. Par exemple, le critère d'erreur peut être égal à la norme euclidienne ou norme 2 de la différence entre les deux réflectogrammes. La norme euclidienne est égale à la racine carrée de la somme des carrés des valeurs de différence point à point entre les deux réflectogrammes. Toute autre distance ou norme peut être envisagée. Le calcul d'erreur peut aussi inclure des pondérations afin de privilégier certaines valeurs temporelles par rapport à d'autre.

A l'étape 505, on supprime les hypothèses de paramètres structurels qui présentent un critère d'erreur élevé. Autrement dit, on sélectionne au moins un indice $i_0$ parmi les indices indexant les hypothèses de paramètres structurels et on supprime toutes les hypothèses $H_{i0,j}$.

Pour cela, on compare chaque critère d'erreur calculé à l'étape 503 à un premier seuil d'erreur dont la valeur est un paramètre fixé de sorte à éliminer les erreurs importantes qui traduisent une trop forte différence entre le réflectogramme mesuré et le réflectogramme simulé. Une autre possibilité est de fixer un pourcentage ou un nombre d'hypothèses de réseaux simulés à supprimer. Par exemple, une seule hypothèse de paramètres structurels (la moins vraisemblable) est éliminée à chaque itération. Si plusieurs hypothèses numériques (indice j) sont disponibles pour chaque hypothèse structurelle (indice i), un critère d'erreur représentatif peut être affecté à l'ensemble des hypothèses numériques pour une hypothèse structurelle, par exemple en effectuant une moyenne.

Dans une autre variante de réalisation, on supprime la ou les hypothèses présentant le ou les critères d'erreur les plus élevés indépendamment des indices i,j.

L'étape 505 permet d'éliminer les topologies dont les paramètres structurels sont peu probables.

A la première itération du procédé, on applique ensuite un algorithme d'optimisation génétique 507 aux réseaux simulés restant après l'étape 505. L'algorithme génétique est appliqué en parallèle à chaque groupe d'hypothèses $H_{i,j}$ ayant les mêmes paramètres structurels mais des paramètres numériques différents.

L'algorithme génétique modifie les réseaux simulés et les réseaux simulés modifiés sont utilisés comme point de départ d'une itération suivante du procédé. Autrement dit, à chaque nouvelle itération, on remplace 508 les réseaux simulés utilisés en entrée de l'étape 504 à l'itération précédente par les réseaux simulés modifiés par l'algorithme génétique 507. Dans ce premier mode de réalisation de l'invention, les modifications apportées aux réseaux simulés concernent uniquement les paramètres numériques des topologies de réseau, c'est-à-dire les longueurs de branches, les valeurs d'impédances caractéristiques des branches et les valeurs des impédances des charges en fin de câble.

Un exemple d'algorithme génétique est décrit dans la référence « Algorithmes génétiques », Selvaraj Ramkumar, 26 avril 2007. Il s'agit d'un algorithme d'optimisation de type métaheuristique. Il consiste, à chaque itération du procédé, à modifier une partie des réseaux simulés par croisement et/ou par mutation. Selon la terminologie employée pour les algorithmes génétiques, un croisement et une mutation s'appliquent à des individus. Un individu correspond à un réseau simulé qui est représenté, dans ce premier mode de réalisation, par un vecteur modèle qui comprend les différents paramètres numériques d'une topologie, c'est-à-dire les longueurs des différentes branches du réseau, les valeurs des impédances caractéristiques des différentes branches du réseau ainsi que les valeurs des impédances des charges en fin de chaque extrémité libre d'une branche. Un croisement est appliqué à deux individus parents pour produire un individu enfant. L'individu enfant est un réseau simulé modifié qui est obtenu en effectuant une combinaison entre les deux individus parents. La combinaison est, par exemple, une combinaison linéaire pondérée en fonction de poids respectifs attribués aux deux individus parents. L'opération de combinaison linéaire est appliquée à au moins un des paramètres numériques de la topologie d'un réseau simulé. Le poids associé à un individu est directement lié à l'erreur calculée à l'étape 504. Ainsi, un individu présentant un critère d'erreur faible se verra affecter un poids plus élevé qu'un individu présentant un critère d'erreur élevé. En sortie de l'étape 507, le nombre d'individus modifiés est identique au nombre d'individus en entrée de l'étape 507. Les individus modifiés par croisement sont chacun obtenus à partir du croisement de deux individus parents. Les individus parents auxquels est appliqué un croisement sont, par exemple, tirés aléatoirement parmi les individus présents en entrée de l'étape 507. Le tirage aléatoire peut être uniforme ou il peut être non uniforme. Dans ce second cas, les individus présentant un poids élevé ont une probabilité plus élevée d'être sélectionnés pour une opération de croisement. Par ailleurs, lorsque deux individus sont sélectionnés pour être croisés, leurs poids respectifs peuvent aussi être utilisés pour pondérer le croisement des valeurs de leurs vecteurs modèles respectifs.

Les réseaux modifiés obtenus en sortie de l'algorithme génétique 507 viennent remplacer 508 à la prochaine itération, les réseaux simulés de l'itération précédente et le procédé reboucle à l'étape 504.

L'étape d'optimisation 507 permet de faire évoluer les paramètres numériques des hypothèses de topologie vers les paramètres les plus vraisemblables.

A partir de la seconde itération du procédé, un test d'arrêt du procédé 506 est mis en œuvre après l'étape 505. Si au moins un réseau simulé présente un critère d'erreur inférieur à un second seuil prédéterminé, alors ce réseau simulé est retenu comme étant le plus probable. Si plusieurs réseaux simulés satisfont le test d'arrêt 506, le procédé fournit plusieurs solutions. Ces solutions peuvent être ensuite discriminées en utilisant une connaissance partielle du réseau réel. Le second seuil du test d'arrêt 506 est un paramètre de l'invention. Il peut être fixé en estimant le niveau de proximité entre deux réflectogrammes à partir duquel on peut considérer que les deux réseaux associés à ces deux réflectogrammes sont identiques. Le second seuil peut notamment être fixé par simulation. Alternativement, le test d'arrêt peut également consister à arrêter le procédé au bout d'une certaine durée et à retenir les réseaux simulés restants à l'issue de l'étape 505 ou à retenir uniquement le réseau simulé présentant le critère d'erreur le plus faible.

Le procédé décrit à la figure 5 permet de reconstruire complètement la topologie d'un réseau inconnu, c'est-à-dire à la fois les paramètres structurels et les paramètres numériques.

Le ou les réseaux simulés retenus à l'issue du procédé peuvent être affichés sur un écran ou toute autre interface équivalente pour être visualisés par un utilisateur.

Le réflectogramme simulé $R_s$ correspondant à la topologie de réseau retenue à l'étape 505 est produit en sortie de l'étape 302 du procédé objet de l'invention décrit à la figure 3. Ce réflectogramme correspond à celui d'un réseau « sain » c'est-à-dire sans défaut.

Dans une variante de réalisation, l'algorithme d'optimisation génétique est remplacé par un algorithme d'optimisation basé sur un algorithme de Newton tel que décrit dans la publication « R. Fletcher, "Practical methods of optimization", John Wiley & Sons, 2013 ».

## Revendications

1. Procédé, mis en œuvre par ordinateur, de caractérisation d'un défaut dans un réseau de lignes de transmission, le procédé comprenant les étapes de :

    - Obtenir (301) un premier réflectogramme temporel mesuré $R_m$ à partir d'un signal préalablement injecté dans le réseau de câbles,
    - Obtenir (302) un second réflectogramme temporel $R_s$ correspondant au réseau de lignes de transmission en l'absence de défauts,

- Déterminer (303) la différence temporelle $R_{ref}$ entre le premier réflectogramme temporel mesuré $R_m$ et le second réflectogramme temporel $R_s$,
- Identifier (304), dans ladite différence temporelle $R_{ref}$, un pic d'amplitude caractérisant la présence d'un défaut et son abscisse temporelle indiquant la position du défaut,
- Simuler (305) une pluralité d'hypothèses de réflectogrammes temporels correspondant chacun audit réseau de câbles comprenant un défaut à ladite position identifiée, chaque hypothèse étant associée à une valeur différente d'au moins un paramètre caractéristique du défaut,
- Sélectionner (306) l'hypothèse de réflectogramme temporel la plus proche de ladite différence temporelle $R_{ref}$,
- Caractériser (307) le défaut à partir de l'au moins un paramètre caractéristique associé à l'hypothèse sélectionnée.

2. Procédé, mis en œuvre par ordinateur, de caractérisation d'un défaut selon la revendication 1 dans lequel le paramètre caractéristique du défaut est pris parmi :

   - la longueur du défaut,
   - la valeur d'au moins un paramètre linéique du défaut parmi la résistance, l'inductance, la capacité ou la conductance,
   - la nature du défaut définie par au moins un paramètre linéique prépondérant du défaut.

3. Procédé, mis en œuvre par ordinateur, de caractérisation d'un défaut selon la revendication 2 dans lequel la valeur d'au moins un paramètre linéique est déterminée par rapport à la valeur du même paramètre linéique de la ligne de transmission.

4. Procédé, mis en œuvre par ordinateur, de caractérisation d'un défaut selon l'une des revendications précédentes dans lequel l'étape de déterminer (306) l'hypothèse de réflectogramme temporel la plus proche de ladite différence temporelle comprend au moins la comparaison de chaque hypothèse de réflectogramme temporel avec ladite différence temporelle sur une fenêtre temporelle autour du pic d'amplitude caractérisant la présence d'un défaut.

5. Procédé, mis en œuvre par ordinateur, de caractérisation d'un défaut selon la revendication 4 dans lequel la comparaison est réalisée au moyen d'un calcul d'erreur entre l'hypothèse de réflectogramme temporel et la différence temporelle.

6. Procédé, mis en œuvre par ordinateur, de caractérisation d'un défaut selon l'une des revendications précédentes dans lequel l'étape de déterminer (306) l'hypothèse de réflectogramme temporel la plus proche de ladite différence temporelle est réalisée au moyen d'un algorithme d'optimisation du type basé sur la méthode de Newton ou du type algorithme génétique.

7. Procédé, mis en œuvre par ordinateur, de caractérisation d'un défaut selon l'une des revendications précédentes dans lequel le second réflectogramme temporel $R_s$ correspondant au réseau de lignes de transmission en l'absence de défauts est déterminé (302) par simulation.

8. Procédé, mis en œuvre par ordinateur, de caractérisation d'un défaut selon l'une des revendications précédentes dans lequel le second réflectogramme temporel $R_s$ correspondant au réseau de lignes de transmission en l'absence de défauts est déterminé (302) par simulation à partir du premier réflectogramme temporel mesuré $R_m$ sans connaissance a priori de la topologie du réseau de lignes.

9. Procédé, mis en œuvre par ordinateur, de caractérisation d'un défaut selon la revendication 8 dans lequel l'étape de déterminer (302) un second réflectogramme temporel $R_s$ correspondant au réseau de lignes de transmission en l'absence de défauts comprend les sous-étapes de :

   - Simuler initialement une pluralité d'hypothèses de réseaux de câbles ($H_{i,j}$), puis exécuter itérativement les étapes suivantes :
   - Obtenir, pour chaque hypothèse de réseau de câbles simulé ($H_{i,j}$), un réflectogramme temporel simulé associé $R_{i,j}$,
   - Evaluer, pour chaque hypothèse de réseau de câbles simulé ($H_{i,j}$), un critère d'erreur $E(R_{i,j}-R_m)$ entre le réflectogramme temporel mesuré $R_m$ et le réflectogramme temporel simulé $R_{i,j}$,
   - Appliquer auxdits réseaux de câbles simulés un algorithme d'optimisation ayant pour fonction de produire une pluralité de réseaux de câbles modifiés présentant globalement un critère d'erreur $E(R_{i,j}-R_m)$ diminué,

- Remplacer lesdits réseaux de câbles simulés de l'itération précédente par lesdits réseaux de câbles modifiés pour l'itération suivante.

10. Procédé, mis en œuvre par ordinateur, de caractérisation d'un défaut selon l'une des revendications précédentes comprenant une étape d'affichage de la localisation du défaut dans le réseau de lignes de transmission et de l'au moins un paramètre caractéristique du défaut, sur un dispositif d'affichage.

11. Procédé, mis en œuvre par ordinateur, de caractérisation d'un défaut selon l'une des revendications précédentes comprenant une étape préalable d'injection du signal dans le réseau de lignes de transmission.

12. Programme d'ordinateur téléchargeable depuis un réseau de communication et/ou enregistré sur un support lisible par ordinateur et/ou exécutable par un processeur, **caractérisé en ce qu'**il comprend des instructions de code pour l'exécution des étapes d'un procédé selon l'une quelconque des revendications 1 à 10, lorsque ledit programme est exécuté sur un ordinateur.

13. Dispositif de caractérisation d'un défaut dans un réseau de lignes de transmission comprenant des moyens, incluant un calculateur et une mémoire, configurés pour mettre en œuvre le procédé selon l'une quelconque des revendications 1 à 11.

**Patentansprüche**

1. Computerimplementiertes Verfahren zum Charakterisieren eines Fehlers in einem Übertragungsleitungsnetz, wobei das Verfahren die folgenden Schritte beinhaltet:

   - Erhalten (301) eines ersten gemessenen Zeit-Reflektogramms $R_m$ auf der Basis eines zuvor in das Kabelnetz eingespeisten Signals,
   - Erhalten (302) eines zweiten Zeit-Reflektogramms Rs entsprechend dem Übertragungsleitungsnetz bei Nichtvorliegen von Fehlern,
   - Bestimmen (303) der Zeitdifferenz $R_{ref}$ zwischen dem ersten gemessenen Zeit-Reflektogramm $R_m$ und dem zweiten Zeit-Reflektogramm $R_s$,
   - Identifizieren (304), in der Zeitdifferenz $R_{ref}$, einer Amplitudenspitze, die das Vorliegen eines Fehlers charakterisiert, und ihrer Zeitabszisse, die die Position des Fehlers angibt,
   - Simulieren (305) mehrerer Hypothesen von Zeit-Reflektogrammen, die jeweils dem Kabelnetz entsprechen, das einen Fehler an der identifizierten Position umfasst, wobei jede Hypothese mit einem unterschiedlichen Wert mindestens eines für den Fehler charakteristischen Parameters verbunden ist,
   - Auswählen (306) der Zeit-Reflektogramm-Hypothese, die der Zeitdifferenz $R_{ref}$ am nächsten kommt;
   - Charakterisieren (307) des Fehlers auf der Basis des mindestens einen mit der ausgewählten Hypothese assoziierten charakteristischen Parameters.

2. Computerimplementiertes Verfahren zum Charakterisieren eines Fehlers nach Anspruch 1, wobei der für den Fehler charakteristische Parameter ausgewählt wird aus:

   - der Länge des Fehlers,
   - dem Wert von mindestens einem linearen Parameter des Fehlers aus Widerstand, Induktivität, Kapazität und Leitfähigkeit,
   - der Art des Fehlers, definiert durch mindestens einen vorherrschenden linearen Parameter des Fehlers.

3. Computerimplementiertes Verfahren zum Charakterisieren eines Fehlers nach Anspruch 2, wobei der Wert von mindestens einem linearen Parameter in Bezug auf den Wert desselben linearen Parameters der Übertragungsleitung bestimmt wird.

4. Computerimplementiertes Verfahren zum Charakterisieren eines Fehlers nach einem der vorhergehenden Ansprüche, wobei der Schritt des Bestimmens (306) der der Zeitdifferenz am nächsten kommenden Zeit-Reflektogramm-Hypothese mindestens das Vergleichen jeder Zeit-Reflektogramm-Hypothese mit der Zeitdifferenz über ein Zeitfenster um die Amplitudenspitze beinhaltet, die das Vorliegen eines Fehlers charakterisiert.

5. Computerimplementiertes Verfahren zum Charakterisieren eines Fehlers nach Anspruch 4, wobei der Vergleich mittels einer Fehlerberechnung zwischen der Zeit-Reflektogramm-Hypothese und der Zeitdifferenz durchgeführt wird.

6. Computerimplementiertes Verfahren zum Charakterisieren eines Fehlers nach einem der vorhergehenden Ansprüche, wobei der Schritt des Bestimmens (306) der der Zeitdifferenz am nächsten kommenden Zeit-Reflektogramm-Hypothese mittels eines Optimierungsalgorithmus des auf dem Newton-Verfahren basierenden Typs oder des genetischen Algorithmustyps durchgeführt wird.

7. Computerimplementiertes Verfahren zum Charakterisieren eines Fehlers nach einem der vorhergehenden Ansprüche, wobei das zweite Zeit-Reflektogramm $R_s$ entsprechend dem Übertragungsleitungsnetz bei Nichtvorliegen von Fehlern durch Simulation bestimmt wird (302).

8. Computerimplementiertes Verfahren zum Charakterisieren eines Fehlers nach einem der vorhergehenden Ansprüche, wobei das zweite Zeit-Reflektogramm $R_s$ entsprechend dem Übertragungsleitungsnetz bei Nichtvorliegen von Fehlern durch Simulation aus dem ersten gemessenen Zeit-Reflektogramm $R_m$ ohne A-priori-Kenntnis der Topologie des Leitungsnetzes bestimmt wird (302).

9. Computerimplementiertes Verfahren zum Charakterisieren eines Fehlers nach Anspruch 8, wobei der Schritt des Bestimmens (302) eines zweiten Zeit-Reflektogramms $R_s$ entsprechend dem Übertragungsleitungsnetz bei Nichtvorliegen von Fehlern die folgenden Teilschritte beinhaltet:

   - anfängliches Simulieren mehrerer Kabelnetzhypothesen ($H_{i,j}$), dann iteratives Ausführen der folgenden Schritte:
   - Erhalten, für jede simulierte Kabelnetzhypothese ($H_{i,j}$), eines assoziierten simulierten Zeit-Reflektogramms $R_{i,j}$,
   - Auswerten, für jede simulierte Kabelnetzhypothese ($H_{i,j}$), eines Fehlerkriteriums $E(R_{i,j}-R_m)$ zwischen dem gemessenen Zeit-Reflektogramm $R_m$ und dem simulierten Zeit-Reflektogramm $R_{i,j}$,
   - Anwenden, auf die simulierten Kabelnetze, eines Optimierungsalgorithmus mit der Aufgabe, mehrere modifizierte Kabelnetze zu erzeugen, die global ein reduziertes Fehlerkriterium $E(R_{i,j}- R_m)$ aufweisen,
   - Ersetzen der simulierten Kabelnetze der vorangegangenen Iteration durch die modifizierten Kabelnetze für die nächste Iteration.

10. Computerimplementiertes Verfahren zum Charakterisieren eines Fehlers nach einem der vorhergehenden Ansprüche, das einen Schritt des Anzeigens des Orts des Fehlers in dem Übertragungsleitungsnetz und des mindestens einen für den Fehler charakteristischen Parameters auf einem Anzeigegerät beinhaltet.

11. Computerimplementiertes Verfahren zum Charakterisieren eines Fehlers nach einem der vorhergehenden Ansprüche, das einen Vorabschritt des Einspeisens des Signals in das Übertragungsleitungsnetz beinhaltet.

12. Computerprogramm, das von einem Kommunikationsnetz heruntergeladen und/oder auf einem computerlesbaren Medium gespeichert und/oder von einem Prozessor ausgeführt werden kann, **dadurch gekennzeichnet, dass** es Codebefehle für die Ausführung der Schritte eines Verfahrens nach einem der Ansprüche 1 bis 10 umfasst, wenn das Programm auf einem Computer ausgeführt wird.

13. Gerät zum Charakterisieren eines Fehlers in einem Übertragungsleitungsnetz, das Mittel, einschließlich eines Rechners und eines Speichers, umfasst, die zum Durchführen des Verfahrens nach einem der Ansprüche 1 bis 11 konfiguriert sind.

**Claims**

1. A computer-implemented method for characterising a fault in a transmission line network, the method comprising the steps of:

   - obtaining (301) a first measured time reflectogram $R_m$ from a signal previously injected into the cable network,
   - obtaining (302) a second time reflectogram $R_s$ corresponding to the transmission line network in the absence of faults,
   - determining (303) the time difference $R_{ref}$ between the first measured time reflectogram $R_m$ and the second time reflectogram $R_s$,

- identifying (304), in said time difference $R_{ref}$, an amplitude peak characterising the presence of a fault and its time abscissa indicating the position of the fault,
- simulating (305) a plurality of time reflectogram hypotheses each corresponding to said cable network comprising a fault at said identified position, each hypothesis being associated with a different value of at least one parameter characteristic of the fault,
- selecting (306) the time reflectogram hypothesis closest to said time difference $R_{ref}$,
- characterising (307) the fault from the at least one characteristic parameter associated with the selected hypothesis.

2. A computer-implemented method for characterising a fault according to claim 1, wherein the parameter characteristic of the fault is taken from among:

- the length of the fault,
- the value of at least one linear parameter of the fault out of the resistance, the inductance, the capacitance or the conductance,
- the nature of the fault defined by at least one predominant linear parameter of the fault.

3. The computer-implemented method for characterising a fault according to claim 2, wherein the value of at least one linear parameter is determined with respect to the value of the same linear parameter of the transmission line.

4. The computer-implemented method for characterising a fault according to one of the preceding claims, wherein the step of determining (306) the time reflectogram hypothesis closest to said time difference comprises at least the comparison of each time reflectogram hypothesis with said time difference over a time window around the amplitude peak characterising the presence of a fault.

5. The computer-implemented method for characterising a fault according to claim 4, wherein the comparison is performed by means of a calculation of error between the time reflectogram hypothesis and the time difference.

6. The computer-implemented method for characterising a fault according to one of the preceding claims, wherein the step of determining (306) the time reflectogram hypothesis closest to said time difference is performed by means of an optimisation algorithm of the type based on the Newton method or of the genetic algorithm type.

7. The computer-implemented method for characterising a fault according to one of the preceding claims, wherein the second time reflectogram $R_s$ corresponding to the transmission line network in the absence of faults is determined (302) by simulation.

8. The computer-implemented method for characterising a fault according to one of the preceding claims, wherein the second time reflectogram $R_s$ corresponding to the transmission line network in the absence of faults is determined (302) by simulation from the first measured time reflectogram $R_m$ with no a priori knowledge of the topology of the line network.

9. The computer-implemented method for characterising a fault according to claim 8, wherein the step of determining (302) a second time reflectogram $R_s$ corresponding to the transmission line network in the absence of faults comprises the substeps of:

- initially simulating a plurality of cable network hypotheses ($H_{i,j}$), then iteratively executing the following steps:
- obtaining, for each simulated cable network hypothesis ($H_{i,j}$), an associated simulated time reflectogram $R_{i,j}$,
- evaluating, for each simulated cable network hypothesis ($H_{i,j}$), an error criterion $E(R_{i,j}-R_m)$ between the measured time reflectogram $R_m$ and the simulated time reflectogram $R_{i,j}$,
- applying to said simulated cable networks an optimisation algorithm whose function is to produce a plurality of modified cable networks globally exhibiting a reduced error criterion $E(R_{i,j}-R_m)$,
- replacing said simulated cable networks of the preceding iteration with said modified cable networks for the next iteration.

10. The computer-implemented method for characterising a fault according to one of the preceding claims, comprising a step of displaying the location of the fault in the transmission line network and the at least one parameter characteristic of the fault, on a display device.

11. The computer-implemented method for characterising a fault according to one of the preceding claims, comprising a preliminary step of injection of the signal into the transmission line network.

12. A computer program that can be downloaded from a communication network and/or stored on a computer-readable medium and/or executable by a processor, **characterised in that** it comprises code instructions for the execution of the steps of a method according to any one of claims 1 to 10, when said program is run on a computer.

13. A device for characterising a fault in a transmission line network comprising means, including a calculator and a memory, configured to implement the method according to any one of claims 1 to 11.

FIG.1

FIG.1bis

FIG.2a

FIG.2b

301 — Obtention premier réflectogramme mesuré $R_m$

302 — Obtention second réflectogramme $R_s$

303 — Différence $R_{ref} = R_m - R_s$

304 — Identification défaut

305 — Paramètres défaut → Simulation hypothèses $H_i$ réflectogrammes → Comparaison $H_i$ et $R_{ref}$ ~ 306

$H_p$

307 — Caractérisation défaut

# FIG.3

FIG.4a

FIG.4b

FIG.4c

FIG.4d

```
┌─────────────────────────────┐
│  Obtention réflectogramme    │ ⟋ 301
│       mesuré R_m             │
└─────────────────────────────┘
              │
              ▼
┌─────────────────────────────┐
│  Simulation hypothèse réseaux│ ⟋ 502
│        de câbles             │
└─────────────────────────────┘
              │  H_{i,j}
              ▼
┌─────────────────────────────┐
│  Obtention réflectogrammes   │ ⟋ 503
│         simulés              │
└─────────────────────────────┘
              │
              ▼
┌─────────────────────────────┐
│ Evaluation erreur entre R_m  │ ⟋ 504
│        et R_{i,j}            │
└─────────────────────────────┘
              │
              ▼
┌─────────────────────────────┐
│  Suppression réseaux simulés │ ⟋ 505
│       peu probables          │
└─────────────────────────────┘
              │
508
┌─────────────────────────────┐
│        Optimisation          │ ⟋ 507
└─────────────────────────────┘
              │
           ◇ Test      ⟋ 506
           ◇ d'arrêt
```

FIG.5

## RÉFÉRENCES CITÉES DANS LA DESCRIPTION

**Documents brevets cités dans la description**

- WO 2017174400 A
- US 7282922 B
- FR 1757650

**Littérature non-brevet citée dans la description**

- **SELVARAJ RAMKUMAR.** *Algorithmes génétiques,* 26 Avril 2007
- **R. FLETCHER.** Practical methods of optimization. John Wiley & Sons, 2013